# EUROPEAN PATENT APPLICATION

(11) **EP 4 800 745 A1**
(43) Date of publication of application: **02.09.2026**
(21) Application number: 24882416.1
(22) Date of filing: 23.10.2024
(51) Int. Cl.: H01L 21/67, H01L 21/52

(54) **PICKUP UNIT AND BONDING DEVICE**

(30) Priority: 25.10.2023 JP 2023183501
(71) Applicant: Panasonic Intellectual Property Management Co., Ltd., Kadoma-shi, Osaka 571-0057 (JP)
(72) Inventor: KUBOTA, Masahiro, Kadoma-shi, Osaka 571-0057 (JP); MOTOMURA, Koji, Kadoma-shi, Osaka 571-0057 (JP); HAMAHIRA, Masaru, Kadoma-shi, Osaka 571-0057 (JP)
(74) Representative: Grünecker Patent- und Rechtsanwälte PartG mbB
(86) International application number: PCT/JP2024/037744
(87) International publication number: WO 2025/089305

(57) **Abstract**

A pickup system (100) includes: a pickup unit (14) that includes a pickup nozzle (14a) and an ultrasonic generator (152a) that vibrates the pickup nozzle (14a) to generate ultrasonic waves; a negative pressure generator (153); a rotational movement mechanism (15b) that rotates the pickup unit (14); and a controller (101). The controller (101) controls the negative pressure generator (153) and the ultrasonic generator (152a) under a first condition when the pickup nozzle (14a) picks up a chip (6a) in a non-contact manner, the controller (101) controls the negative pressure generator (153) and the ultrasonic generator (152a) under a second condition when the rotational movement mechanism (15b) rotates the pickup unit (14), and a repulsive force to the chip (6a) by the ultrasonic generator (152a) under the second condition is weaker than a repulsive force to the chip (6a) by the ultrasonic generator (152a) under the first condition.

## Description

### [Technical Field]

The present disclosure relates to a unit for picking up a component or the like.

### [Background Art]

In order to achieve higher functionality in a semiconductor package, hybrid bonding that does not use bumps, bonding materials, and the like is required. In hybrid bonding, in a state where a surface of a semiconductor chip is cleaned, the semiconductor chip is bonded to a substrate or the like by utilization of hydrogen bonding or the like. Hence, in hybrid bonding, it is necessary to keep the surface of the semiconductor chip highly clean after the semiconductor chip is picked up from a dicing tape that is an adhesive sheet until the semiconductor chip is bonded.

Therefore, a chip holder that uses a chip holding tool to hold, in a non-contact manner, a semiconductor chip pushed upward from below a dicing tape and a manufacturing device that includes the chip holder have been conventionally proposed (see Patent Literature (PTL) 1, for example). It should be noted that the chip holding tool is also referred to as a nozzle or a pickup nozzle, and the chip holder is also referred to as a pickup unit. Moreover, the manufacturing device is also referred to as a bonding device because the manufacturing device bonds a semiconductor chip as a component to a substrate. The chip holder disclosed in PTL 1 uses ultrasonic waves and a suction force to hold, in a non-contact manner, a semiconductor chip pushed upward from below a dicing tape.

### [Citation List]

### [Patent Literature]

[PTL 1] Japanese Unexamined Patent Application Publication No. 2023-45216

### [Summary of Invention]

### [Technical Problem]

However, it is difficult for the chip holder (i.e., pickup unit) disclosed in PTL 1 to properly hold a semiconductor chip that is a component.

Therefore, the present disclosure provides a pickup unit or the like that can properly hold a component in a non-contact manner.

### [Solution to Problem]

A pickup unit according to an aspect of the present disclosure is a pickup unit for picking up a component in a non-contact manner and includes: an ultrasonic generator that produces vibration to generate an ultrasonic wave; a nozzle that picks up the component in the non-contact manner using the ultrasonic wave generated; and an ultrasonic horn that is connected to the ultrasonic generator and the nozzle and transmits the vibration of the ultrasonic generator to the nozzle, wherein a suction passage for sucking the component is provided inside the ultrasonic horn, and the nozzle includes: a suction hole connected to the suction passage; a first portion that is connected to the ultrasonic horn and has a first width; and a second portion that is connected to the first portion and has a second width that is greater than the first width.

It should be noted that a general or specific aspect of this may be realized by a system, a device, or a method, or may be realized by any combination of a system, a device, and a method.

### [Advantageous Effects of Invention]

A pickup unit according to the present disclosure can properly hold a component in a non-contact manner.

It should be noted that further advantages and effects in an aspect of the present disclosure will be apparent from the specification and the drawings. Although such advantages and/or effects are provided by some embodiments and configurations described in the specification and the drawings, not all of the configurations are necessarily required.

### [Brief Description of Drawings]

[FIG. 1]

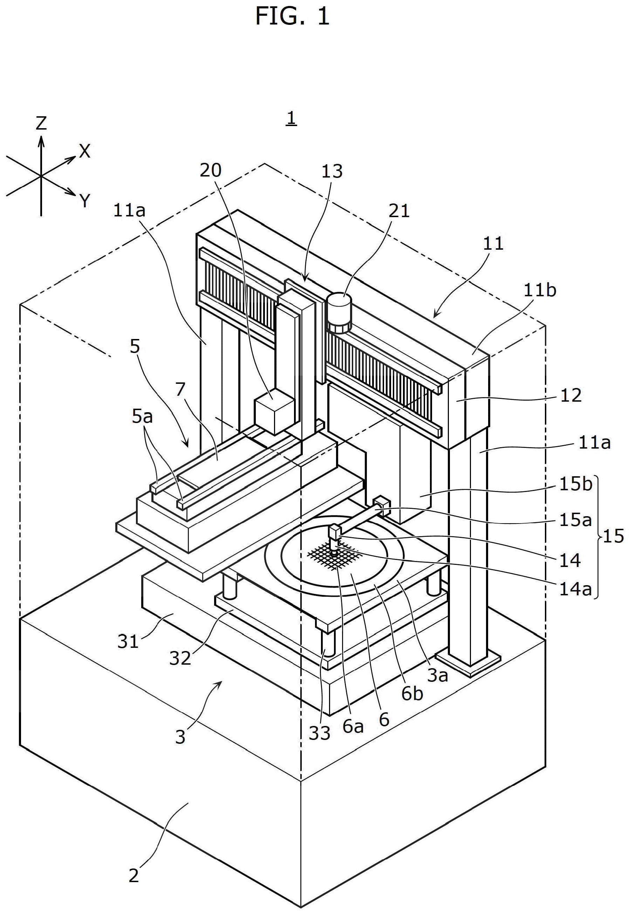

   FIG. 1 is a perspective view of a component mounting device according to an embodiment.
[FIG. 2]

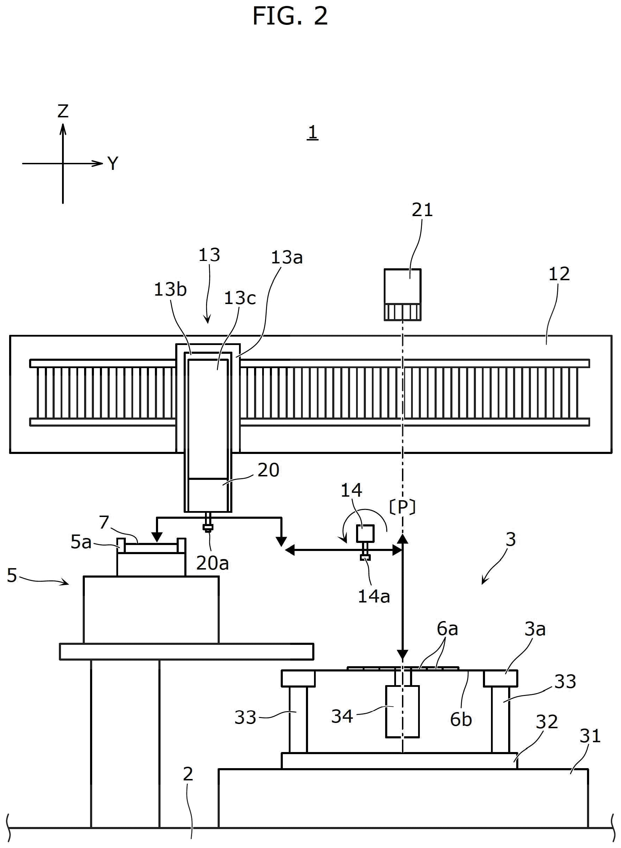

   FIG. 2 is a diagram for illustrating an operation in which the component mounting device according to the embodiment mounts a chip on a substrate.
[FIG. 3]

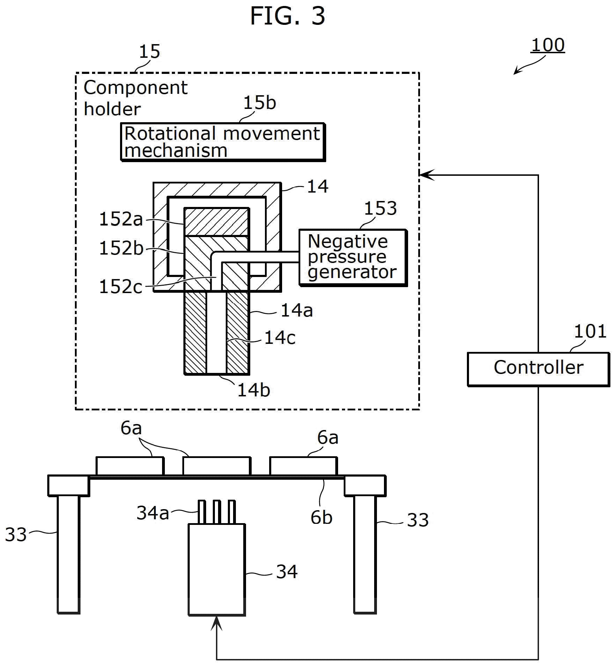

   FIG. 3 is a diagram illustrating an example of a configuration of a pickup system according to the embodiment.
[FIG. 4A]

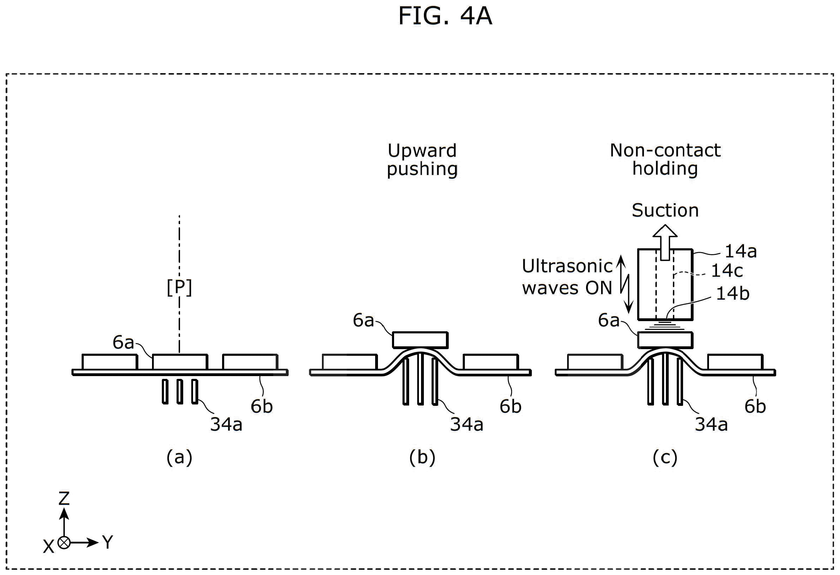

   FIG. 4A is a diagram for illustrating part of an example of an operation in which the pickup system according to the embodiment uses a pickup nozzle to pick up a chip and transfers the chip to a component mounting nozzle.
[FIG. 4B]

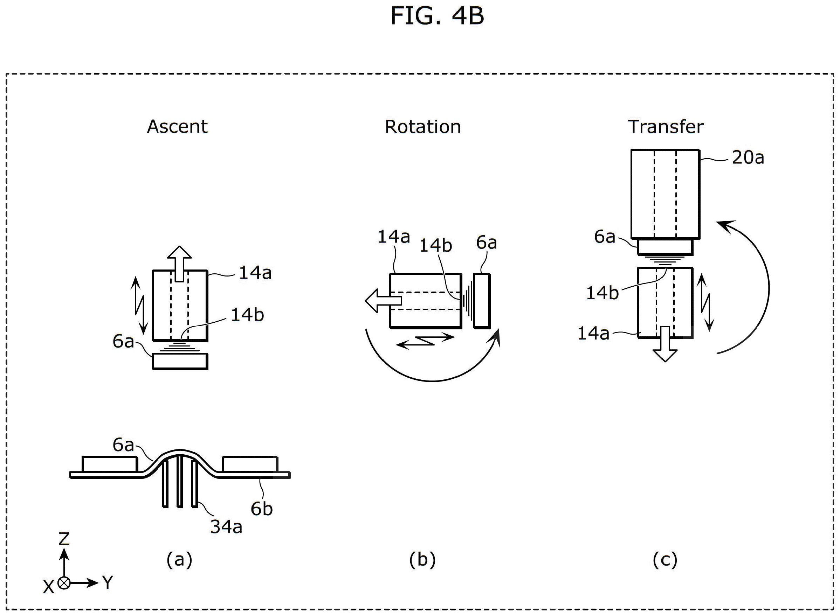

   FIG. 4B is a diagram for illustrating the rest of the example of the operation in which the pickup system according to the embodiment uses the pickup nozzle to pick up the chip and transfers the chip to the component mounting nozzle.
[FIG. 5]

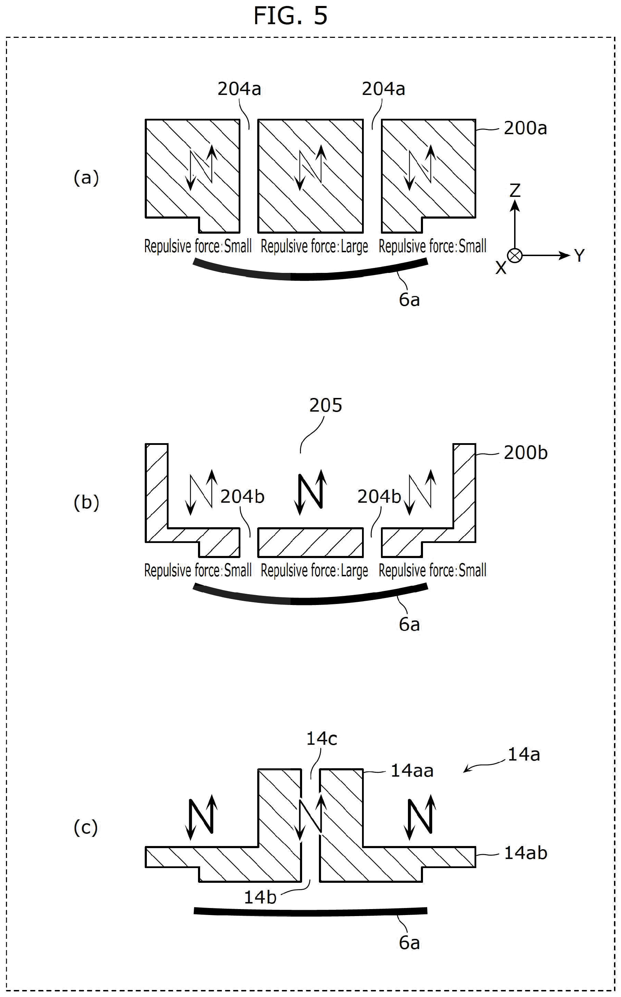

   FIG. 5 is a diagram for illustrating the pickup nozzle according to the embodiment.
[FIG. 6]

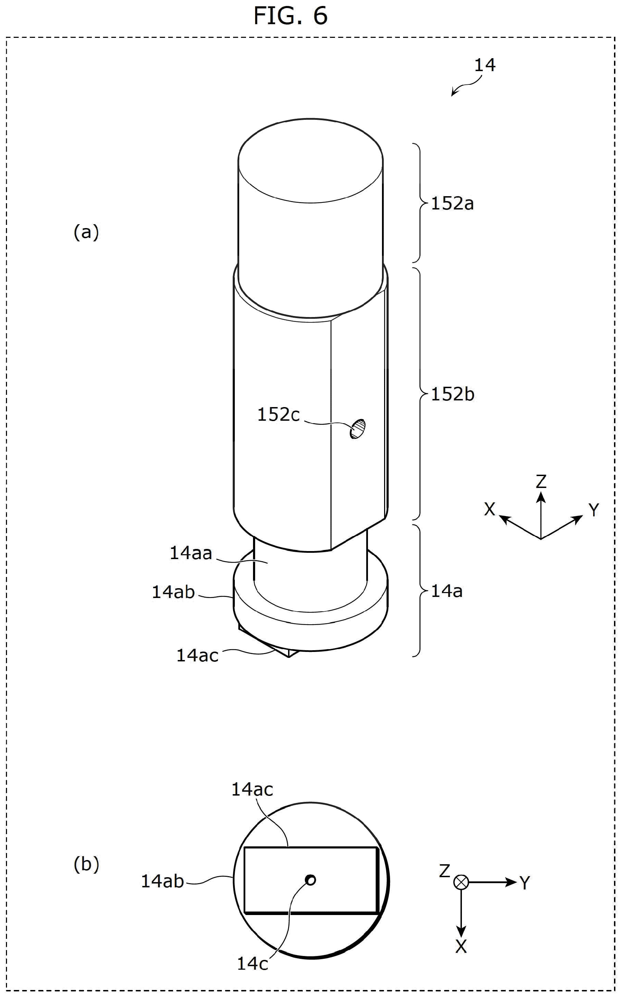

   FIG. 6 is a diagram illustrating an example of an external view of a pickup unit according to the embodiment.
[FIG. 7]

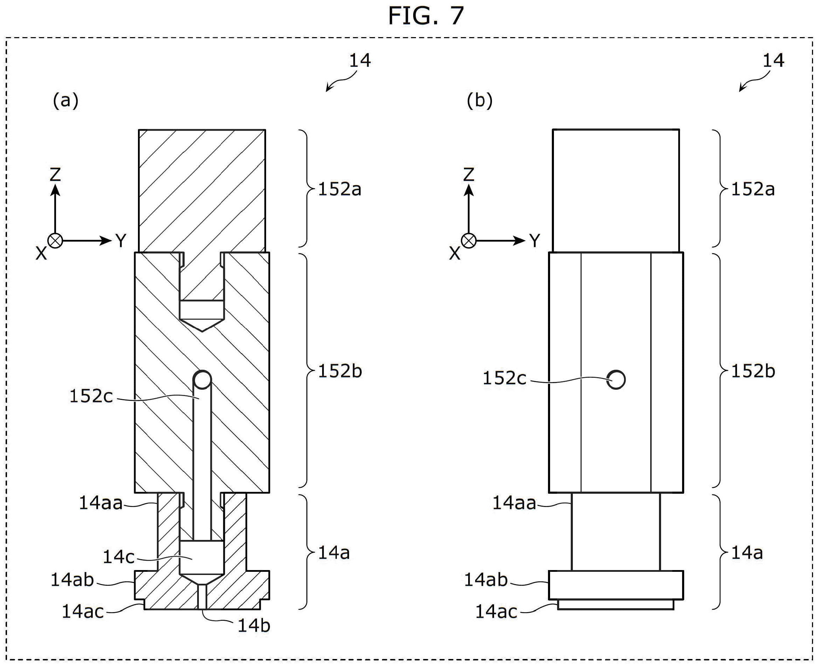

   FIG. 7 is a diagram illustrating an example of a state where the pickup unit according to the embodiment is viewed from the negative side in the X-axis direction.
[FIG. 8]

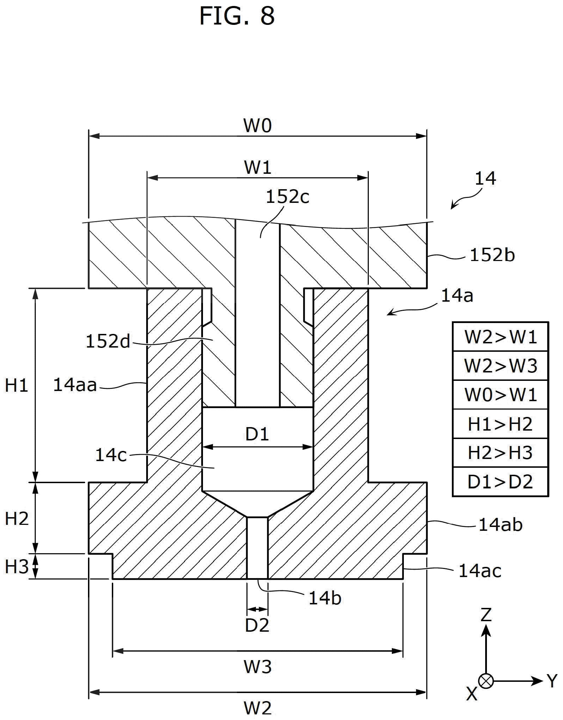

   FIG. 8 is a partial cross-sectional view of the pickup unit according to the embodiment on a YZ plane.
[FIG. 9]

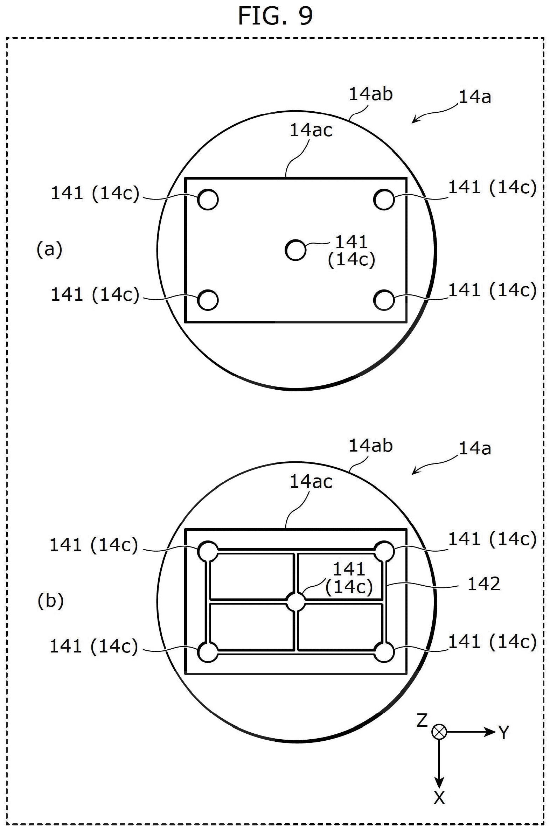

   FIG. 9 is a diagram for illustrating another example of the pickup nozzle according to the embodiment.

### [Description of Embodiment]

The present inventors have discovered the following problem regarding the chip holder disclosed in PTL 1 described in [Background Art]. The chip holder disclosed in PTL 1 uses a chip holding tool provided with a suction hole to pick up a semiconductor chip. In other words, the semiconductor chip is drawn toward the chip holding tool by suction of air through the suction hole of the chip holding tool. Meanwhile, due to an ultrasonic squeeze effect, a force that moves the semiconductor chip away from the chip holding tool acts on the semiconductor chip. Thus, the semiconductor chip is held in a non-contact manner by the chip holding tool. However, the suction hole is provided to a central portion of the chip holding tool in the chip holder disclosed in PTL 1. Accordingly, in a case where a semiconductor chip is held in a non-contact manner by the chip holding tool so that a central portion of the semiconductor chip faces the central portion of the chip holding tool, the central portion of the semiconductor chip is drawn toward the chip holding tool more strongly than a peripheral portion of the semiconductor chip. As a result, the semiconductor chip is distorted so as to warp.

Then, it is conceivable to set the number, arrangement, shape, or the like of suction holes so that a force that draws a semiconductor chip toward the chip holding tool, that is, a suction force, acts uniformly on a surface of the semiconductor chip. However, even in a case where the suction force acts uniformly, there may be a case where a repulsive force due to ultrasonic waves, that is, a force that moves a semiconductor chip away from the chip holding tool by ultrasonic waves, does not act uniformly on the surface of the semiconductor chip. For example, there may be a case where a stronger repulsive force may be generated at the central portion of the chip holding tool than at a peripheral portion of the chip holding tool. In such a case, the central portion of the semiconductor chip receives the stronger repulsive force than the peripheral portion of the semiconductor chip, and thus is moved away from the chip holding tool. As a result, the semiconductor chip is distorted so as to warp.

As described above, it is difficult to hold a semiconductor chip in a non-contact manner without distorting the semiconductor chip. In particular, when a semiconductor chip is thin, the semiconductor chip will be significantly distorted. When a semiconductor chip picked up is distorted, the semiconductor chip may contact the chip holding tool or may be displaced from the chip holding tool. Moreover, when the semiconductor chip is transferred from the chip holding tool to other equipment, it may be difficult for the equipment to properly receive the semiconductor chip. As a result, the equipment may improperly bond the semiconductor chip to a substrate.

In order to overcome such a problem, a pickup unit according to a first aspect of the present disclosure is a pickup unit for picking up a component in a non-contact manner and includes: an ultrasonic generator that produces vibration to generate an ultrasonic wave; a nozzle that picks up the component in the non-contact manner using the ultrasonic wave generated; and an ultrasonic horn that is connected to the ultrasonic generator and the nozzle and transmits the vibration of the ultrasonic generator to the nozzle, wherein a suction passage for sucking the component is provided inside the ultrasonic horn, and the nozzle includes: a suction hole connected to the suction passage; a first portion that is connected to the ultrasonic horn and has a first width; and a second portion that is connected to the first portion and has a second width that is greater than the first width.

Accordingly, in the second portion, a portion that protrudes beyond the first portion in the width direction can vibrate with a larger amplitude than the first portion. In other words, an end portion, in the width direction, of the nozzle can vibrate with a larger amplitude than a central portion of the nozzle. It should be noted that, for example, the width direction is a direction perpendicular to the arrangement direction in which the first portion and the second portion are arranged, and the vibration is the vibration in the arrangement direction. Moreover, the end portion can resonate with the vibration transmitted from the ultrasonic generator via the ultrasonic horn and the first portion. Then, ultrasonic waves are generated by the vibration and a repulsive force that is a force that moves the component away from the nozzle is obtained from the ultrasonic waves. Accordingly, the repulsive force at the end portion can be made larger than in a conventional one, and the possibility of making the distribution of the repulsive force uniform in the width direction can be increased. In other words, the possibility of generating a uniform squeeze film pressure can be increased. Thus, the possibility of applying a uniform repulsive force to each portion, in the width direction, of the component can be increased. As a result, the component can be properly held in a non-contact manner while suppressing warpage or distortion of the component.

Moreover, in a pickup unit according to a second aspect, the second portion may be in a cylindrical shape. It should be noted that the pickup unit according to the second aspect may be dependent on the pickup unit according to the first aspect.

Accordingly, the vibration of the ultrasonic generator is easily transmitted to the second portion and ultrasonic waves can be efficiently generated because the second portion is in the same cylindrical shape as the ultrasonic generator (more specifically, ultrasonic transducer), for example. Moreover, when the first portion is connected to the upper surface of the second portion, the distribution of the repulsive force can be made axially symmetric with respect to the central axis of the second portion. As a result, an influence of the orientation of the nozzle when the component is picked up can be suppressed. It should be noted that the orientation of the nozzle is an orientation that changes according to rotation of the nozzle about the above-described central axis.

Moreover, in a pickup unit according to a third aspect, the suction hole may pass through a center of the second portion. It should be noted that the pickup unit according to the third aspect may be dependent on the pickup unit according to the first aspect or the second aspect.

Accordingly, the center of the component can be properly drawn toward the nozzle by suction using the suction hole, and the component can be properly held in a non-contact manner while keeping the balance of the component in the horizontal direction.

Moreover, in a pickup unit according to a fourth aspect, the suction hole may include a plurality of holes each passing through the second portion. It should be noted that the pickup unit according to the fourth aspect may be dependent on the pickup unit according to any one of the first aspect to the third aspect.

Accordingly, a suction force that draws the component toward the nozzle can be dispersed by suction using the holes. As a result, the possibility of applying the suction force uniformly to a surface of the component can be increased, and stable non-contact holding of the component can be realized while suppressing warpage or distortion of the component.

Moreover, in a pickup unit according to a fifth aspect, the nozzle may be configured to be attachable to and detachable from the ultrasonic horn. It should be noted that the pickup unit according to the fifth aspect may be dependent on the pickup unit according to any one of the first aspect to the fourth aspect.

Accordingly, depending on the shape, size, etc. of a component that is to be picked up, the nozzle attached to the ultrasonic horn can be replaced with a nozzle that is suitable for the component. As a result, the component can be properly held in a non-contact manner.

Moreover, in a pickup unit according to a sixth aspect, the ultrasonic horn may include a protrusion that is connected to the first portion of the nozzle, the first portion of the nozzle may include a recess corresponding to the protrusion, and the ultrasonic horn and the nozzle may be connected by threadedly engaging the protrusion with the recess. It should be noted that the pickup unit according to the sixth aspect may be dependent on the pickup unit according to any one of the first aspect to the fifth aspect.

Thus, the ultrasonic horn and the nozzle can be securely bonded, and the vibration of the ultrasonic generator can be easily transmitted to the nozzle.

Moreover, in a pickup unit according to a seventh aspect, the nozzle may further include a third portion that is connected to the second portion and is in a shape corresponding to a shape of the component, and the suction hole may pass through the second portion and the third portion. It should be noted that the pickup unit according to the seventh aspect may be dependent on the pickup unit according to any one of the first aspect to the sixth aspect.

Accordingly, since there is the third portion that is in the shape corresponding to the shape of the component, the component can be properly held in a non-contact manner without being constrained by the shape and size of the second portion.

Moreover, in a pickup unit according to an eighth aspect, the third portion may be in a rectangular shape including a side in a longitudinal direction and a side in a transverse direction. It should be noted that the pickup unit according to the eighth aspect may be dependent on the pickup unit according to the seventh aspect. Specifically, the rectangular shape is a shape of a surface of the third portion that faces the component.

Accordingly, the component in the rectangular shape can be properly held in a non-contact manner.

Moreover, in a pickup unit according to a ninth aspect, the second portion may be in a cylindrical shape, and a diameter of the second portion in the cylindrical shape may be greater than a length of the side in the longitudinal direction of the third portion. It should be noted that the pickup unit according to the ninth aspect may be dependent on the pickup unit according to the eighth aspect.

Accordingly, an end portion, in the longitudinal direction, of the third portion can be vibrated with a large amplitude. Consequently, the possibility of applying a uniform repulsive force to each portion, in the longitudinal direction, of the component can be increased. As a result, the component can be properly held in a non-contact manner while suppressing warpage or distortion of the component.

Moreover, in a pickup unit according to a tenth aspect, the first width of the first portion may be less than a width of the ultrasonic horn. It should be noted that the pickup unit according to the tenth aspect may be dependent on the pickup unit according to any one of the first aspect to the ninth aspect.

Accordingly, since the first width of the first portion is small, the second portion that has the second width larger than the first width can be easily designed. Moreover, the second width of the second portion can be kept small. As a result, the component can be properly held in a non-contact manner while downsizing the pickup unit.

Moreover, in a pickup unit according to an eleventh aspect, a height of the first portion may be greater than a height of the second portion. It should be noted that the pickup unit according to the eleventh aspect may be dependent on the pickup unit according to any one of the first aspect to the tenth aspect.

Accordingly, the size of the second portion can be kept small. Moreover, the pickup unit that vibrates at a low resonant frequency can be designed more easily when the first portion is higher than the second portion. As a result, the pickup unit that has a large amplitude at an end portion of the second portion and vibrates at a desired resonance frequency can be easily miniaturized.

Moreover, in a pickup unit according to a twelfth aspect, the second width may be at least 20% greater than the first width. It should be noted that the pickup unit according to the twelfth aspect may be dependent on the pickup unit according to any one of the first aspect to the eleventh aspect.

Accordingly, the vibration of the above-described end portion can be effectively increased, and warpage and distortion of the component can be appropriately suppressed.

Moreover, a bonding device according to the first aspect of the present disclosure includes: the pickup unit according to any one of the first aspect to the twelfth aspect; and a bonding unit that receives the component from the pickup unit and bonds the component received to an other component. It should be noted that the other component may be a substrate.

Accordingly, in the bonding device according to the first aspect, an effect equivalent to that of the pickup unit according to any one of the first to twelfth aspects can be achieved.

Hereinafter, an embodiment will be specifically described with reference to the drawings.

It should be noted that the embodiment described below indicates a general or specific example. Numerical values, shapes, materials, constituent elements, the arrangement and connection of the constituent elements, steps, the order of the steps, and the like shown in the following embodiment are examples, and are not intended to limit the present disclosure. Moreover, among the constituent elements in the following embodiment, constituent elements that are not recited in the independent claim indicating the highest level of concept are described as optional constituent elements. Furthermore, the respective figures are schematic diagrams and are not necessarily precise illustrations. Furthermore, in the drawings, the same constituent members are identified with the same reference signs. Furthermore, in the embodiment below, expressions such as 'approximately the same' are used. For example, 'approximately the same' means not only completely the same, but also substantially the same, including, for example, an error of about several percent. Moreover, 'approximately the same' means the same within a range in which the effect of the present disclosure can be achieved. This applies to other phrases where 'approximately' is used as well.

### (Embodiment)

FIG. 1 is a perspective view of a component mounting device according to the present embodiment.

Component mounting device 1 according to the present embodiment picks up a component, and mounts the component picked up on substrate 7. Hence, component mounting device 1 according to the present embodiment includes a pickup system that picks up a component. It should be noted that the mounting of the component on substrate 7 is also referred to as bonding of the component to substrate 7. Therefore, component mounting device 1 is also referred to as a bonding device. Moreover, substrate 7 according to the present embodiment is not limited to a specific type of substrate, and may be a silicon substrate, a component, a silicon chip, or the like. Furthermore, in the present disclosure, a vertical direction is referred to as a Z-axis direction or an up-down direction, and one direction in a plane perpendicular to the vertical direction is referred to as a Y-axis direction, a left-right direction, or a lateral direction, and in the plane perpendicular to the vertical direction, a direction perpendicular to the Y-axis direction is referred to as an X-axis direction or a depth direction. Furthermore, in the present disclosure, a positive side in the Z-axis direction is upward or up, and a negative side in the Z-axis direction is downward or down. Furthermore, in the present disclosure, a positive side in the Y-axis direction is a right side or right, and a negative side in the Y-axis direction is a left side or left. Furthermore, in the present disclosure, a positive side in the X-axis direction is a back side or back, and a negative side in the X-axis direction is a front side or front. Furthermore, an example of a component is a semiconductor chip or a chip. Furthermore, in the present disclosure, picking up particularly means an operation of picking up a component from an adhesive sheet such as a dicing tape in an operation of holding the component or an operation in which the component is being held.

Component mounting device 1 includes base 2, component supplier 3, substrate holder 5, component holder 15, frame 11, Y-axis driving mechanism 12, component mounter 13, and pickup camera 21. Base 2 is the base of component mounting device 1, and supports constituent members included in component mounting device 1.

Component supplier 3 is placed on base 2, and supplies a component to component holder 15. Component supplier 3 as described above includes holding table 3a, XY table mechanism 31, movement plate 32, and support members 33. Holding table 3a holds semiconductor wafer unit 6 in a state where semiconductor wafer unit 6 is along a horizontal direction. Semiconductor wafer unit 6 includes adhesive sheet 6b and chips 6a. Chips 6a are individual pieces or semiconductor chips obtained by dicing a semiconductor wafer, and are components that are supplied by component supplier 3 and mounted on substrate 7. Adhesive sheet 6b is a sheet that has adhesive properties and is also referred to as a dicing tape. Chips 6a adhere to the upper surface of adhesive sheet 6b. Each of support members 33 is a columnar member that is placed on movement plate 32 so as to stand upright from movement plate 32. Support members 33 support holding table 3a in a state where semiconductor wafer unit 6 held on holding table 3a is separated upward from movement plate 32. Movement plate 32 is a plate that is disposed in XY table mechanism 31. XY table mechanism 31 moves movement plate 32 in the X-axis direction and in the Y-axis direction. Along with the movement of movement plate 32, semiconductor wafer unit 6 is moved in the X-axis direction and in the Y-axis direction. In other words, chips 6a are moved along the XY plane.

Pickup camera 21 is disposed above component supplier 3, and images chip 6a that is to be picked up in semiconductor wafer unit 6.

Substrate holder 5 holds substrate 7 in a state where substrate 7 is along the horizontal direction. Substrate holder 5 as described above includes conveyance rail 5a. Substrate holder 5 locates and holds substrate 7 conveyed by conveyance rail 5a in a mounting position. The mounting position is a position in which mounting of chip 6a is performed.

Component holder 15 includes arm 15a, rotational movement mechanism 15b, and pickup unit 14. Arm 15a is a columnar member, and is attached to rotational movement mechanism 15b in a state where arm 15a is along the X-axis direction. In other words, one end (that is, a base end), in the longitudinal direction, of arm 15a is attached to rotational movement mechanism 15b. Moreover, pickup unit 14 is attached to the other end (that is, a tip end) of arm 15a.

Rotational movement mechanism 15b is suspended from Y-axis frame 11b of frame 11, and moves arm 15a in the X-axis direction, in the Y-axis direction, and in the Z-axis direction. Moreover, rotational movement mechanism 15b rotates arm 15a about the central axis along the longitudinal direction of arm 15a. In other words, rotational movement mechanism 15b rotates arm 15a about the X-axis. Pickup unit 14 is attached to the tip end of arm 15a as described above. Moreover, pickup unit 14 includes pickup nozzle 14a that is made of, for example, metal and holds chip 6a in a non-contact manner by vacuum suction and ultrasonic waves. It should be noted that vacuum suction is an action of sucking air and is also simply referred to as suction. Hence, pickup nozzle 14a is driven by rotational movement mechanism 15b to move in the X-axis direction, in the Y-axis direction, and in the Z-axis direction, and to rotate about the X-axis. Moreover, rotational movement mechanism 15b moves pickup nozzle 14a based on a result of imaging performed by pickup camera 21. In this way, rotational movement mechanism 15b can lower pickup nozzle 14a to accurately position pickup nozzle 14a close to the upper surface of chip 6a that is to be picked up. It should be noted that pickup nozzle 14a according to the present embodiment is also simply referred to as a nozzle, and includes an opening for holding chip 6a in a non-contact manner by vacuum suction and ultrasonic waves.

Frame 11 is disposed on base 2 on the positive side in the X-axis direction, and includes two support posts 11a and long Y-axis frame 11b. Two support posts 11a support Y-axis frame 11b in a state where Y-axis frame 11b is along the Y-axis direction and is separated upward from the upper surface of base 2. In other words, Y-axis frame 11b is suspended by two support posts 11a. Moreover, as described above, rotational movement mechanism 15b is suspended from Y-axis frame 11b.

Y-axis driving mechanism 12 is attached to the X-axis direction negative side surface of Y-axis frame 11b and moves component mounter 13 in the Y-axis direction. Component mounter 13 includes mounting unit 20. Component mounter 13 uses mounting unit 20 to receive, from pickup nozzle 14a, chip 6a held by pickup nozzle 14a, and mounts chip 6a on substrate 7 located in the mounting position.

FIG. 2 is a diagram for illustrating an operation in which component mounting device 1 mounts chip 6a on substrate 7.

Component mounting device 1 picks up, among chips 6a adhering to adhesive sheet 6b, chip 6a disposed in pickup operation position P that is previously set in the XY plane, and mounts chip 6a on substrate 7.

Specifically, XY table mechanism 31 moves movement plate 32 in the X-axis direction and in the Y-axis direction to dispose, in pickup operation position P, chip 6a that is to be picked up. Chip 6a that is disposed in pickup operation position P as described above and that is to be picked up is pushed upward by upward pusher 34.

In other words, as illustrated in FIG. 2, component mounting device 1 according to the present embodiment includes upward pusher 34 disposed in pickup operation position P. It should be noted that upward pusher 34 may be included in component supplier 3. Upward pusher 34 pushes chip 6a adhering to adhesive sheet 6b upward from below via adhesive sheet 6b. Specifically, upward pusher 34 upwardly pushes chip 6a that is disposed in pickup operation position P and that is to be picked up.

Pickup camera 21 is disposed above component supplier 3 and in pickup operation position P. Pickup camera 21 as described above images, from above component supplier 3, pickup operation position P and the surrounding area thereof, among chips 6a adhering to adhesive sheet 6b. In this way, chip 6a that is to be picked up is imaged, and the position of chip 6a that is to be picked up is recognized based on the result of the imaging. In other words, recognition of the position of chip 6a is performed.

Pickup nozzle 14a of pickup unit 14 is driven by rotational movement mechanism 15b to move downward, to approach, from above, chip 6a whose position has been recognized based on the result of the imaging performed by pickup camera 21, and to hold chip 6a described above. Then, pickup nozzle 14a moves upward in a state where pickup nozzle 14a holds chip 6a, and further moves toward, for example, the negative side in the Y-axis direction. Here, the lower surface (that is, bottom surface) of chip 6a held by pickup nozzle 14a is directed upward by rotation of arm 15a by rotational movement mechanism 15b. In this way, chip 6a is held in an upside-down state by pickup nozzle 14a.

As illustrated in FIG. 2, component mounter 13 includes not only mounting unit 20 described above but also movement plate 13a, ascent/descent mechanism 13b, and ascent/descent plate 13c. Movement plate 13a is a plate attached to Y-axis driving mechanism 12 so that movement plate 13a is movable in the Y-axis direction. In other words, movement plate 13a is driven by Y-axis driving mechanism 12 to move in the Y-axis direction.

Ascent/descent mechanism 13b is attached to the front surface of movement plate 13a to cause ascent/descent plate 13c to ascend and descend. Mounting unit 20 is attached to a lower part of ascent/descent plate 13c. Mounting unit 20 includes component mounting nozzle 20a. Component mounting nozzle 20a receives chip 6a from pickup nozzle 14a that holds chip 6a in the upside-down state, for example. For example, component mounting nozzle 20a is driven by Y-axis driving mechanism 12 and ascent/descent mechanism 13b to move to a position above chip 6a and to hold chip 6a by, for example, vacuum suction. Then, component mounting nozzle 20a moves toward substrate 7 along the Y-axis direction in a state where component mounting nozzle 20a holds chip 6a, and mounts chip 6a on substrate 7.

Component mounter 13 according to the present embodiment as described above is an example of a bonding unit that bonds chip 6a held by pickup unit 14 of component holder 15 to an other component such as substrate 7. Accordingly, a bonding device that is component mounting device 1 according to the present embodiment includes: pickup unit 14; and the bonding unit that receives chip 6a from pickup unit 14 and bonds chip 6a received to an other component. It should be noted that when receiving chip 6a, the bonding unit according to the present embodiment receives chip 6a from pickup unit 14 after pickup unit 14 has been rotated by rotational movement mechanism 15b.

FIG. 3 is a diagram illustrating an example of a configuration of the pickup system according to the present embodiment.

Pickup system 100 according to the present embodiment is a system that is included in component mounting device 1, and includes, for example, component holder 15 described above, upward pusher 34, and controller 101.

Component holder 15 includes pickup unit 14, negative pressure generator 153, and rotational movement mechanism 15b. Moreover, pickup unit 14 is a mechanism for picking up chip 6a in a non-contact manner, and includes pickup nozzle 14a, ultrasonic generator 152a, and ultrasonic horn 152b.

Ultrasonic generator 152a vibrates to generate ultrasonic waves. In other words, ultrasonic generator 152a includes, for example, a Langevin-type ultrasonic transducer, and vibrates (i.e., ultrasonically vibrates) in accordance with a voltage applied to the ultrasonic transducer. Ultrasonic horn 152b is connected to ultrasonic generator 152a and pickup nozzle 14a, amplifies vibration of ultrasonic generator 152a, and transmits the vibration to pickup nozzle 14a. As a result, ultrasonic waves are generated from around opening 14b of pickup nozzle 14a. In other words, pickup nozzle 14a ultrasonically vibrates in the up-down direction to transmit the resulting vibration to the air contacting the lower surface of pickup nozzle 14a. For example, ultrasonic generator 152a ultrasonically vibrates pickup nozzle 14a with an amplitude of about 10 to 20 µm at maximum. Pickup nozzle 14a picks up chip 6a in a non-contact manner using ultrasonic waves generated by the vibration.

Negative pressure generator 153 generates a negative pressure around opening 14b of pickup nozzle 14a. In the present embodiment, negative pressure generator 153 is configured, for example, as a vacuum pump. Specifically, suction passage 152c that is a hole for sucking chip 6a is provided in ultrasonic horn 152b, and pickup nozzle 14a includes suction hole 14c that is connected to suction passage 152c and communicates with opening 14b. Negative pressure generator 153 generates a negative pressure around opening 14b of pickup nozzle 14a by making the pressure in suction passage 152c and suction hole 14c negative. In other words, negative pressure generator 153 generates a negative pressure around opening 14b by sucking the air around opening 14b via suction passage 152c and suction hole 14c. Moreover, negative pressure generator 153 includes an adjustment valve that adjusts a negative pressure, and generates a negative pressure of a magnitude corresponding to the opening degree of the adjustment valve.

Pickup nozzle 14a holds chip 6a in a non-contact manner around opening 14b, based on: a repulsive force that results from ultrasonic waves generated by ultrasonic generator 152a and moves chip 6a away from pickup nozzle 14a; and a suction force that results from a negative pressure generated by negative pressure generator 153 and draws chip 6a toward pickup nozzle 14a. It should be noted that the repulsive force described above is a force resulting from formation of a squeeze film by ultrasonic waves.

Rotational movement mechanism 15b includes, for example, a motor or the like, and causes pickup nozzle 14a to move in the X-axis direction, in the Y-axis direction, and in the Z-axis direction. Moreover, rotational movement mechanism 15b rotates arm 15a to rotate pickup nozzle 14a of pickup unit 14 attached to the tip end of arm 15a. The time required for pickup nozzle 14a to rotate 180 degrees, that is, the time required for pickup nozzle 14a to turn over, is less than 0.5 seconds, for example.

Upward pusher 34 includes upward pushing pins 34a, and causes upward pushing pins 34a to ascend and descend. Upward pushing pins 34a ascend to push up adhesive sheet 6b, and thus chip 6a adhering to adhesive sheet 6b is pushed upward.

Controller 101 controls upward pusher 34 and component holder 15. In other words, controller 101 controls upward pusher 34, ultrasonic generator 152a, negative pressure generator 153, and rotational movement mechanism 15b. For example, controller 101 controls a voltage applied to the ultrasonic transducer of ultrasonic generator 152a to adjust a repulsive force applied to chip 6a. Moreover, controller 101 controls the adjustment valve of negative pressure generator 153 to adjust a suction force applied to chip 6a. Thus, a repulsive force and a suction force applied to chip 6a can be effectively adjusted.

It should be noted that although ultrasonic generator 152a and negative pressure generator 153 are included in component holder 15 in the present embodiment, ultrasonic generator 152a and negative pressure generator 153 do not need to be included in component holder 15. Moreover, although ultrasonic horn 152b and pickup nozzle 14a are separate elements in the present embodiment, they may be configured integrally.

FIG. 4A and FIG. 4B are diagrams illustrating an example of an operation in which pickup system 100 according to the present embodiment uses pickup nozzle 14a to pick up chip 6a and transfers chip 6a to component mounting nozzle 20a.

For example, XY table mechanism 31 moves movement plate 32 to move adhesive sheet 6b held by holding table 3a in the X-axis direction and in the Y-axis direction. By the movement of adhesive sheet 6b, chip 6a that is to be picked up is disposed in pickup operation position P, as illustrated in (a) of FIG. 4A. In other words, chip 6a that is to be picked up is disposed above upward pushing pins 34a of upward pusher 34.

Then, upward pusher 34 causes pushing pins 34a to ascend to push chip 6a upward via adhesive sheet 6b, as illustrated in (b) of FIG. 4A. Thereafter, pickup nozzle 14a descends, ultrasonic generator 152a generates ultrasonic waves, and negative pressure generator 153 generates a negative pressure, as illustrated in (c) of FIG. 4A. Specifically, according to the control performed by controller 101, ultrasonic generator 152a vibrates pickup nozzle 14a via ultrasonic horn 152b to generate ultrasonic waves from around opening 14b of pickup nozzle 14a. The ultrasonic waves generated by ultrasonic generator 152a are, for example, ultrasonic waves generated by pickup nozzle 14a vibrating at a vibration speed of at least 10 mm/s and at most 5000 mm/s. Moreover, negative pressure generator 153 sucks air according to the control performed by controller 101. In this way, a negative pressure is generated around opening 14b of pickup nozzle 14a. Consequently, controller 101 causes pickup nozzle 14a to hold chip 6a in a non-contact manner by using a suction force generated by the negative pressure around opening 14b and a repulsive force generated by the ultrasonic waves around opening 14b. In other words, pickup nozzle 14a holds chip 6a in a non-contact manner by using the suction force that draws chip 6a toward opening 14b of pickup nozzle 14a and the repulsive force that moves chip 6a away from opening 14b. In the non-contact holding as described above, a gap having a width of about 20 µm to 60 µm is generated between pickup nozzle 14a and chip 6a, for example.

Thereafter, controller 101 controls rotational movement mechanism 15b to cause pickup nozzle 14a to ascend, as illustrated in (a) of FIG. 4B. In other words, chip 6a is removed from adhesive sheet 6b and ascends. Moreover, controller 101 controls rotational movement mechanism 15b to cause pickup nozzle 14a to rotate, as illustrated in (b) of FIG. 4B. In other words, rotational movement mechanism 15b rotates arm 15a to rotate pickup nozzle 14a by 180 degrees so that opening 14b of pickup nozzle 14a facing downward is caused to face upward, as illustrated in (b) and (c) of FIG. 4B. Namely, pickup unit 14 attached to the tip end of arm 15a is turned over according to the rotation of arm 15a. As a result, pickup nozzle 14a included in pickup unit 14 is turned over. Accordingly, chip 6a held in a non-contact manner by pickup nozzle 14a is also turned over and the lower surface of chip 6a, which is the surface that had adhered to adhesive sheet 6b, is caused to face upward. It should be noted that before pickup nozzle 14a is turned over, rotational movement mechanism 15b may cause pickup nozzle 14a to move in the X-axis direction and in the Y-axis direction to a chip transfer position. The chip transfer position is a position in which chip 6a is transferred to component mounting nozzle 20a.

Then, component mounting nozzle 20a sucks and holds, from above, chip 6a that has been turned over, as illustrated in (c) of FIG. 4B. As a result, chip 6a is transferred from pickup nozzle 14a to component mounting nozzle 20a.

FIG. 5 is a diagram for illustrating pickup nozzle 14a according to the present embodiment. It should be noted that each of (a) and (b) of FIG. 5 schematically illustrates an example of a cross section of a pickup nozzle according to a comparative example in the YZ plane, and (c) of FIG. 5 schematically illustrates an example of a cross section of pickup nozzle 14a according to the present embodiment in the YZ plane. Moreover, each of the solid arrows in FIG. 5 indicates the magnitude and direction of vibration.

For example, suction holes 204a for sucking chip 6a are provided in pickup nozzle 200a illustrated in (a) of FIG. 5. Moreover, due to vibration of an ultrasonic generator, pickup nozzle 200a vibrates with approximately the same amplitude at each position in the XY plane, as illustrated in (a) of FIG. 5. For example, the amplitude of the vibration at a central portion, in the Y-axis direction, of pickup nozzle 200a is approximately the same as the amplitude of the vibration at an end portion, in the Y-axis direction, of pickup nozzle 200a. However, due to the characteristics of a squeeze film, the distribution of a repulsive force generated by ultrasonic waves in the XY plane does not become uniform. In other words, the repulsive force at a central portion, in the XY plane, of pickup nozzle 200a is greater than the repulsive force at an end portion, in the XY plane, of pickup nozzle 200a. Accordingly, because the repulsive force is not uniform as described above even when a suction force is uniformly applied to the upper surface of chip 6a by suction through suction holes 204a, chip 6a may be warped or distorted. In other words, chip 6a may be warped or distorted so that a central portion of chip 6a protrudes downward.

Moreover, suction holes 204b for sucking chip 6a and hollow portion 205 that communicates with suction holes 204b are provided in pickup nozzle 200b illustrated in (b) of FIG. 5. Since hollow portion 205 is provided in pickup nozzle 200b described above, the thickness of a portion of pickup nozzle 200b that faces chip 6a is thin. Accordingly, due to vibration of an ultrasonic generator, pickup nozzle 200b vibrates with a larger amplitude than pickup nozzle 200a illustrated in (a) of FIG. 5. However, since hollow portion 205 is provided in pickup nozzle 200b described above, a central portion, in the XY plane, of pickup nozzle 200b vibrates with a larger amplitude than an end portion thereof. Therefore, the distribution of a repulsive force in pickup nozzle 200b is less uniform than that in pickup nozzle 200a. In other words, the repulsive force at the central portion, in the XY plane, of pickup nozzle 200b is greater than the repulsive force, in the XY plane, of the end portion. Accordingly, even when a suction force acts uniformly on the upper surface of chip 6a by suction through suction holes 204b, chip 6a may be warped or distorted so that a central portion of chip 6a further protrudes downward.

Such warpage or distortion of chip 6a becomes more significant as chip 6a becomes thinner. In particular, when chip 6a is a silicon chip and the thickness of chip 6a is less than or equal to 100 µm, there is a high possibility that chip 6a warps, and the thinner chip 6a is, the higher the possibility of warping becomes.

Then, pickup nozzle 14a according to the present embodiment includes first portion 14aa and second portion 14ab that are different from each other in width in the Y-axis direction, as illustrated in (c) of FIG. 5. Specifically, first portion 14aa is located above second portion 14ab, connected to ultrasonic horn 152b, and has a first width. The first width is a width in the Y-axis direction. Moreover, second portion 14ab is connected to first portion 14aa and has a second width that is greater than the first width. As described above, pickup nozzle 14a according to the present embodiment is connected to ultrasonic horn 152b, and includes: first portion 14aa that has the first width; and second portion 14ab that is connected to first portion 14aa and has the second width greater than the first width. It should be noted that although the first width and the second width are widths in the Y-axis direction in the example illustrated in (c) of FIG. 5, the first width and the second width may be widths in the X-axis direction or widths in the X-axis direction and in the Y-axis direction. In other words, the first width and the second width may be widths in any direction along the XY plane. It should be noted that such a direction that defines the first width and the second width may also be referred to as a width direction. Moreover, the width direction may also be referred to as a direction perpendicular to the arrangement direction in which first portion 14aa and second portion 14ab are arranged (i.e., a direction along the XY plane).

Thus, a portion of second portion 14ab that protrudes in the width direction beyond first portion 14aa can vibrate with a larger amplitude than first portion 14aa. It should be noted that even in a portion of second portion 14ab that does not protrude beyond first portion 14aa, the closer to an end side in the width direction of that portion, the larger the amplitude of vibration compared to a central portion thereof. In other words, an end portion, in the XY plane, of pickup nozzle 14a can vibrate with a larger amplitude than a central portion, in the XY plane, of pickup nozzle 14a. Moreover, the end portion can resonate with vibration transmitted from ultrasonic generator 152a via ultrasonic horn 152b and first portion 14aa. Then, ultrasonic waves are generated by the vibration and a repulsive force is obtained by the ultrasonic waves. Accordingly, the repulsive force at the end portion can be increased compared with the examples illustrated in (a) and (b) of FIG. 5, and the possibility of making the distribution of the repulsive force in the XY plane uniform can be increased. In other words, the possibility of generating a uniform squeeze film pressure can be increased. Accordingly, the possibility of applying a uniform repulsive force to each portion, in the XY plane, of chip 6a can be increased. As a result, chip 6a can be properly held or picked up in a non-contact manner while suppressing warpage or distortion of chip 6a.

FIG. 6 is a diagram illustrating an example of an external view of pickup unit 14. It should be noted that (a) of FIG. 6 is a perspective view of pickup unit 14 and (b) of FIG. 6 is a diagram illustrating the external view of pickup unit 14 viewed from the negative side in the Z-axis direction.

As illustrated in (a) of FIG. 6, pickup unit 14 includes ultrasonic generator 152a, ultrasonic horn 152b, and pickup nozzle 14a that are connected in the stated order from the positive side in the Z-axis direction. Pickup nozzle 14a includes first portion 14aa, second portion 14ab, and third portion 14ac that are connected in the stated order from the positive side in the Z-axis direction. In the present embodiment, second portion 14ab is in a cylindrical shape. Since second portion 14ab is in the same cylindrical shape as the ultrasonic transducer of ultrasonic generator 152a, vibration of ultrasonic generator 152a can be easily transmitted to second portion 14ab and ultrasonic waves can be efficiently generated. Moreover, the distribution of a repulsive force can be made axially symmetric with respect to the central axis of second portion 14ab. As a result, an influence of the orientation of pickup nozzle 14a when chip 6a is picked up can be suppressed. It should be noted that the orientation of pickup nozzle 14a is an orientation that is changed by rotation of pickup nozzle 14a about the central axis described above.

Moreover, regardless of the direction along the XY plane in which the first width of first portion 14aa and the second width of second portion 14ab are measured, the second width is greater than the first width. Accordingly, second portion 14ab can vibrate with a large amplitude as described above.

Moreover, third portion 14ac is connected to second portion 14ab and is in a shape corresponding to the shape of chip 6a. Accordingly, because there is third portion 14ac that is in the shape corresponding to the shape of chip 6a, chip 6a can be properly held in a non-contact manner without being constrained by the shape and size of second portion 14ab. Specifically, third portion 14ac is connected to the lower surface of second portion 14ab and is in a rectangular parallelepiped shape. The rectangular parallelepiped shape is the shape corresponding to the shape of chip 6a. In other words, the lower surface of third portion 14ac is approximately the same in shape and size as the upper surface of chip 6a. More specifically, third portion 14ac, that is, the lower surface of third portion 14ac is in a rectangular shape including a side in a longitudinal direction and a side in a transverse direction. Accordingly, chip 6a in the rectangular shape can be properly held in a non-contact manner.

FIG. 7 is a diagram illustrating an example of a state where pickup unit 14 is viewed from the negative side in the X-axis direction. It should be noted that (a) of FIG. 7 is a cross-sectional view of pickup unit 14 in the YZ plane, and (b) of FIG. 7 is a front view of pickup unit 14.

Suction hole 14c communicates with suction passage 152c of ultrasonic horn 152b, and passes through the center of each of first portion 14aa, second portion 14ab, and third portion 14ac, as illustrated in (a) of FIG. 7. Accordingly, the center of chip 6a can be properly drawn toward pickup nozzle 14a by suction through suction hole 14c, and chip 6a can be properly held in a non-contact manner while keeping the balance of chip 6a in the horizontal direction.

Moreover, a portion of suction hole 14c passing through first portion 14aa, a portion of suction hole 14c passing through second portion 14ab, and a portion of suction hole 14c passing through third portion 14ac differ from each other in size or shape. A cross section, in the XY plane, of the portion of suction hole 14c passing through first portion 14aa is in an approximately circular shape, and the portion of suction hole 14c passing through first portion 14aa has a uniform size in the Z-axis direction. Meanwhile, although a cross section, in the XY plane, of the portion of suction hole 14c passing through second portion 14ab is also in an approximately circular shape, the portion of suction hole 14c passing through second portion 14ab tapers toward the negative side in the Z-axis direction. Moreover, a cross section, in the XY plane, of the portion of suction hole 14c passing through third portion 14ac is the same as opening 14b in shape and size, and the portion of suction hole 14c passing through third portion 14ac has a uniform size in the Z-axis direction.

Ultrasonic horn 152b is connected to pickup nozzle 14a by being inserted into suction hole 14c on the first portion 14aa side of pickup nozzle 14a. Moreover, suction passage 152c of ultrasonic horn 152b is open at a surface of ultrasonic horn 152b on the negative side in the X-axis direction, as illustrated in (b) of FIG. 7. Accordingly, when suction passage 152c described above is connected to negative pressure generator 153 via a pipe or a tube, one end of the pipe or tube is connected to suction passage 152c that is open at the surface of ultrasonic horn 152b on the negative side in the X-axis direction.

FIG. 8 is a partial cross-sectional view of pickup unit 14 on the YZ plane. Specifically, FIG. 8 is an enlarged view illustrating pickup nozzle 14a and its surroundings in pickup unit 14.

Pickup nozzle 14a is configured to be attachable to and detachable from ultrasonic horn 152b. Therefore, depending on the shape, size, etc. of chip 6a that is to be picked up, pickup nozzle 14a attached to ultrasonic horn 152b can be replaced with pickup nozzle 14a that is suitable for chip 6a described above. As a result, chip 6a can be properly held in a non-contact manner. Specifically, as illustrated in FIG. 8, ultrasonic horn 152b includes protrusion 152d that is connected to first portion 14aa of pickup nozzle 14a. Protrusion 152d described above protrudes downward. Moreover, suction passage 152c passes through the center of protrusion 152d in the Z-axis direction. First portion 14aa of pickup nozzle 14a includes a recess corresponding to protrusion 152d. In the present embodiment, the recess is formed by a portion of pickup nozzle 14a surrounding suction hole 14c, more specifically, by a portion of first portion 14aa surrounding suction hole 14c. Ultrasonic horn 152b and pickup nozzle 14a are connected to each other by threadedly engaging protrusion 152d with the recess (i.e., suction hole 14c). In other words, a male screw is provided in one of protrusion 152d or the recess, a female screw is provided in the other of protrusion 152d or the recess, and ultrasonic horn 152b and pickup nozzle 14a are connected to each other by screwing protrusion 152d and the recess together. Thus, ultrasonic horn 152b and pickup nozzle 14a can be securely bonded and vibration of ultrasonic generator 152a can be easily transmitted to pickup nozzle 14a.

It should be noted that ultrasonic horn 152b and pickup nozzle 14a may be connected to each other through threaded engagement via a rod-shaped connecting member. For example, ultrasonic horn 152b includes a recess provided with a female screw and the connecting member is provided with a male screw. One end side of the connecting member is inserted into and threadedly engaged with the recess of ultrasonic horn 152b, and the other end side of the connecting member protrudes downward from ultrasonic horn 152b. The other end side of the connecting member described above is used as protrusion 152d described above. Then, the other end side of the connecting member is inserted into and threadedly engaged with the recess of pickup nozzle 14a that is provided with the female screw. Thus, the female screws are fastened to each other via the male screw. Even in this case, ultrasonic horn 152b and pickup nozzle 14a can be securely bonded and vibration of ultrasonic generator 152a can be easily transmitted to pickup nozzle 14a.

It should be noted that diameter D1 of a portion of suction hole 14c located in first portion 14aa is greater than diameter D2, in the Y-axis direction, of opening 14b. Then, an upper portion of the portion having diameter D1 is filled with protrusion 152d and a lower portion of the portion having diameter D1 is hollow.

Moreover, in the present embodiment, width W2 that is the second width of second portion 14ab is greater than width W1 that is the first width of first portion 14aa, as described above. Accordingly, an end portion, in the width direction, of second portion 14ab can be vibrated with a large amplitude. For example, width W2 that is the second width may be at least 20% greater than width W1 that is the first width. Namely, width W2 may be at least 1.2 times as large as width W1. Accordingly, vibration of the above-described end portion can be effectively increased, and warpage and distortion of chip 6a can be appropriately suppressed. Moreover, width W2 may be at least 50% greater than width W1. Namely, width W2 may be at least 1.5 times as large as width W1. A specific example of width W1 is 9 mm, and a specific example of width W2 is 14 mm. It should be noted that because second portion 14ab is in a cylindrical shape in the present embodiment, width W2 corresponds to the diameter of second portion 14ab.

Moreover, width W2 that is the diameter of second portion 14ab in the cylindrical shape is greater than length W3 of a side, in the longitudinal direction, of third portion 14ac. Accordingly, an end portion, in the longitudinal direction, of third portion 14ac can be vibrated with a large amplitude. Consequently, the possibility of applying a uniform repulsive force to each portion, in the longitudinal direction, of chip 6a can be increased. As a result, chip 6a can be properly held or picked up in a non-contact manner while suppressing warpage or distortion of chip 6a.

Moreover, width W1 that is the first width of first portion 14aa is less than width WO of ultrasonic horn 152b. Although width W1 and width WO are each a width in the Y-axis direction in the example of FIG. 8, they may each be a width in any direction as long as the direction is a direction perpendicular to the arrangement direction in which ultrasonic horn 152b and first portion 14aa are arranged, that is, a direction along the XY plane. Accordingly, because width W1 that is the first width of first portion 14aa is small, second portion 14ab having width W2 (i.e., second width) that is larger than width W1 can be easily designed. Moreover, width W2 of second portion 14ab can be kept small. As a result, chip 6a can be properly held in a non-contact manner while downsizing pickup unit 14.

Moreover, height H1 of first portion 14aa is greater than height H2 of second portion 14ab. Accordingly, the size of second portion 14ab can be kept small. Moreover, pickup unit 14 that vibrates at a low resonant frequency can be designed more easily when first portion 14aa is higher than second portion 14ab. As a result, pickup unit 14 that vibrates with a large amplitude at an end portion of second portion 14ab and vibrates at a desired resonance frequency can be easily miniaturized. It should be noted that the smaller width W1 and the larger height H1, the easier it is to design pickup unit 14 that vibrates at a lower resonant frequency. Moreover, height H3 of third portion 14ac may be less than height H2 of second portion 14ab.

FIG. 9 is a diagram for illustrating another example of pickup nozzle 14a according to the present embodiment. It should be noted that FIG. 9 illustrates an external view of pickup nozzle 14a viewed from the negative side in the Z-axis direction.

Suction hole 14c may include holes 141 each of which passes through second portion 14ab and third portion 14ac of pickup nozzle 14a, as illustrated in (a) of FIG. 9. These holes 141 may communicate in first portion 14aa. Accordingly, a suction force that draws chip 6a toward pickup nozzle 14a by suction through holes 141 can be dispersed. As a result, the possibility of applying a uniform suction force to a surface of chip 6a can be increased, and stable non-contact holding of chip 6a can be realized while suppressing warpage or distortion of chip 6a.

For example, pickup nozzle 14a includes five holes 141. Four holes 141 among five holes 141, more specifically, openings of four holes 141 are arranged at the four corners of a component-facing surface of third portion 14ac. Moreover, the remaining one hole 141, more specifically, an opening of the remaining one hole 141 is disposed at the center of the component-facing surface. It should be noted that the component-facing surface is a rectangular surface that faces chip 6a when picking up chip 6a.

Accordingly, when chip 6a that includes an upper surface having the same shape and the same size as those of the component-facing surface of third portion 14ac is picked up, chip 6a can be properly drawn toward pickup nozzle 14a by suction through five holes 141. In other words, each portion, in the XY plane, of chip 6a can be drawn toward pickup nozzle 14a by a uniform force. It should be noted that the number of holes 141 is not limited to five, and may be any number equal to or greater than two. Moreover, at the center of the component-facing surface, the number of holes 141 is not limited to one, and a plurality of holes 141 may be provided.

Furthermore, as illustrated in (b) of FIG. 9, one or more grooves 142 may be provided in the component-facing surface of third portion 14ac. These one or more grooves 142 are provided so that, for example, holes 141 at the four corners and hole 141 at the center are connected. A negative pressure is also generated at and around one or more grooves 142. Accordingly, since suction is performed via one or more grooves 142, a portion between a central portion and a peripheral portion of chip 6a can also be drawn toward pickup nozzle 14a, and warpage or distortion of chip 6a can be effectively suppressed.

Although pickup system 100 and pickup unit 14 and the like according to one or more aspects have been described based on the embodiment, the present disclosure is not limited to the embodiment. Forms obtained by various modifications to the above-described embodiment that can be conceived by a person skilled in the art may be included in the scope of the present disclosure as long as they do not depart from the essence of the present disclosure.

For example, a vibration mode of pickup nozzle 14a according to the above-described embodiment may be a longitudinal first-order mode or a higher-order mode in which a node is provided in the component-facing surface. Moreover, in the case of the higher-order mode, pickup nozzle 14a may vibrate in a mode in which waves of vibration propagate radially from the center of the component-facing surface toward the end portion. Alternatively, when the ratio of a long side to a short side of the rectangular component-facing surface is large, pickup nozzle 14a may vibrate in a higher-order mode in which waves of vibration propagate in the longitudinal direction of the component-facing surface.

Moreover, although pickup nozzle 14a holds chip 6a in a non-contact manner in the above-described embodiment, component mounting nozzle 20a may also hold chip 6a in a non-contact manner in the same manner as pickup nozzle 14a.

It should be noted that in Embodiment 1, controller 101 or the like may be configured of dedicated hardware or may be realized by executing a software program suitable for controller 101 or the like. Controller 101 may be realized by a program executor, such as a central processing unit (CPU) or a processor, reading and executing a software program recorded in a recording medium, such as a hard disk or a semiconductor memory.

It should be noted that the following cases are also included in the present disclosure.

(1) Controller 101 may specifically be a computer system that includes a microprocessor, a read only memory (ROM), a random access memory (RAM), a hard disk unit, a display unit, a keyboard, a mouse, and the like. In the RAM or the hard disk unit, a computer program is stored. The microprocessor is operated according to the computer program, and thus controller 101 achieves its function. Here, the computer program is configured by combining a plurality of instruction codes indicating commands to the computer in order to achieve a predetermined function.
(2) Controller 101 may be configured of one system large scale integration (LSI) circuit. The system LSI circuit is a super-multifunctional LSI circuit that is manufactured by integrating a plurality of constituent units on one chip, and is specifically a computer system that includes a microprocessor, a ROM, a RAM, and the like. In the RAM, a computer program is stored. The microprocessor is operated according to the computer program, and thus the system LSI circuit achieves its function.
(3) Controller 101 may be configured of a removable IC card or a single module. The IC card or the module is a computer system that includes a microprocessor, a ROM, a RAM, and the like. The IC card or the module may include the super-multifunctional LSI circuit described above. The microprocessor is operated according to a computer program, and thus the IC card or the module achieves its function. The IC card or the module may be tamper-resistant.

### [Industrial Applicability]

For example, the present disclosure can be utilized for a device, a unit, a system, and the like that pick up a component to perform an operation using the component.

### [Reference Signs List]

- 1: component mounting device (bonding device)
- 2: base
- 3: component supplier
- 3a: holding table
- 5: substrate holder
- 5a: conveyance rail
- 6: semiconductor wafer unit
- 6a: chip (component)
- 6b: adhesive sheet
- 7: substrate
- 11: frame
- 11a: support post
- 11b: Y-axis frame
- 12: Y-axis driving mechanism
- 13: component mounter
- 13a: movement plate
- 13b: ascent/descent mechanism
- 13c: ascent/descent plate
- 14: pickup unit
- 14a,200a,200b: pickup nozzle (nozzle)
- 14aa: first portion
- 14ab: second portion
- 14ac: third portion
- 14b: opening
- 14c,204a,204b: suction hole
- 15: component holder
- 15a: arm
- 15b: rotational movement mechanism
- 20: mounting unit
- 20a: component mounting nozzle
- 21: pickup camera
- 31: XY table mechanism
- 32: movement plate
- 33: support member
- 34: upward pusher
- 34a: upward pushing pin
- 100: pickup system
- 101: controller
- 141: hole
- 142: groove
- 152a: ultrasonic generator
- 152b: ultrasonic horn
- 152c: suction passage
- 153: negative pressure generator

## Claims

1. A pickup unit for picking up a component in a non-contact manner, the pickup unit comprising:
an ultrasonic generator that produces vibration to generate an ultrasonic wave;
a nozzle that picks up the component in the non-contact manner using the ultrasonic wave generated; and
an ultrasonic horn that is connected to the ultrasonic generator and the nozzle and transmits the vibration of the ultrasonic generator to the nozzle, wherein
a suction passage for sucking the component is provided inside the ultrasonic horn, and
the nozzle includes:
a suction hole that is connected to the suction passage;
a first portion that is connected to the ultrasonic horn and has a first width; and
a second portion that is connected to the first portion and has a second width that is greater than the first width.

2. The pickup unit according to claim 1, wherein
the second portion is in a cylindrical shape.

3. The pickup unit according to claim 1, wherein
the suction hole passes through a center of the second portion.

4. The pickup unit according to claim 1, wherein
the suction hole includes a plurality of holes each of which passes through the second portion.

5. The pickup unit according to claim 1, wherein
the nozzle is configured to be attachable to and detachable from the ultrasonic horn.

6. The pickup unit according to claim 5, wherein
the ultrasonic horn includes a protrusion that is connected to the first portion of the nozzle,
the first portion of the nozzle includes a recess corresponding to the protrusion, and
the ultrasonic horn and the nozzle are connected by threadedly engaging the protrusion with the recess.

7. The pickup unit according to claim 1, wherein
the nozzle further includes a third portion that is connected to the second portion and is in a shape corresponding to a shape of the component, and
the suction hole passes through the second portion and the third portion.

8. The pickup unit according to claim 7, wherein
the third portion is in a rectangular shape including a side in a longitudinal direction and a side in a transverse direction.

9. The pickup unit according to claim 8, wherein
the second portion is in a cylindrical shape, and
a diameter of the second portion in the cylindrical shape is greater than a length of the side in the longitudinal direction of the third portion.

10. The pickup unit according to claim 1, wherein
the first width of the first portion is less than a width of the ultrasonic horn.

11. The pickup unit according to claim 10, wherein
a height of the first portion is greater than a height of the second portion.

12. The pickup unit according to claim 1, wherein
the second width is at least 20% greater than the first width.

13. A bonding device comprising:
the pickup unit according to any one of claims 1 to 12; and
a bonding unit that receives the component from the pickup unit and bonds the component received to an other component.
